**Europäisches Patentamt**

**European Patent Office**

**Office européen des brevets**

(19)

(11) Veröffentlichungsnummer : **0 326 977 B1**

(12) ## EUROPÄISCHE PATENTSCHRIFT

(45) Veröffentlichungstag der Patentschrift :
26.08.92 Patentblatt 92/35

(51) Int. Cl.$^5$ : **G03F 7/033**

(21) Anmeldenummer : **89101498.7**

(22) Anmeldetag : **28.01.89**

(54) **Flächenförmiges lichtempfindliches Aufzeichnungsmaterial.**

Die Akte enthält technische Angaben, die nach dem Eingang der Anmeldung eingereicht wurden und die nicht in dieser Patentschrift enthalten sind.

(30) Priorität : **05.02.88 DE 3803457**

(43) Veröffentlichungstag der Anmeldung :
**09.08.89 Patentblatt 89/32**

(45) Bekanntmachung des Hinweises auf die Patenterteilung :
**26.08.92 Patentblatt 92/35**

(84) Benannte Vertragsstaaten :
**DE FR GB IT NL SE**

(56) Entgegenhaltungen :
**FR-A- 2 283 187**

(56) Entgegenhaltungen :
**CHEMICAL ABSTRACTS, Band 82, Nr. 18, 5. Mai 1975, Seite 55, Nr. 112950j, Columbus, Ohio, US; & JP-A-49 19 711 (T. YASHIMAet al.) 20-05-1974**

(73) Patentinhaber : **BASF Aktiengesellschaft
Carl-Bosch-Strasse 38
W-6700 Ludwigshafen (DE)**

(72) Erfinder : **Kurtz, Karl-Rudolf, Dr.
Schloss-Wolfs-Brunnen-Weg 62
W-6900 Heidelberg (DE)**
Erfinder : **Koch, Horst, Dr.
Tiefenthaler Strasse 47
W-6718 Gruenstadt (DE)**
Erfinder : **Telser, Thomas, Dr.
Kurpfalzstrasse 9
W-6905 Schriesheim (DE)**
Erfinder : **Zuerger, Manfred
Holderlandstrasse 2
W-6920 Sinsheim (DE)**

## Beschreibung

Die vorliegende Erfindung betrifft ein flächenförmiges lichtempfindliches Aufzeichnungsmaterial I, das ein polymeres Bindemittel, einen Initiator, ein Monomeres mit mindestens einer photopolymerisierbaren Doppelbindung und gegebenenfalls Hilfsstoffe enthält, das dadurch gekennzeichnet ist, daß es mindestens eine photopolymerisierbare reliefbildende Schicht (A) enthält, welche, bezogen auf (A),

$a_1$) 20 bis 99,499 Gew.% mindestens eines polymeren Bindemittels aus der Gruppe der statistischen Ethylen-Propylen-Alkadien-Terpolymerisate eines Ethylengehalts von 40 bis 80 Gew.% und eines Doppelbindungsanteils von 2 bis 20 olefinischen Doppelbindungen je 1000 Kohlenstoffatome,

$a_2$) 0,001 bis 10 Gew.% mindestens eines Initiators der Photopolymerisation,

$a_3$) 0,5 bis 50 Gew.% mindestens eines Monomeren, welches mit dem Bindemittel (a1) verträglich ist und mindestens eine photopolymerisierbare olefinische Doppelbindung aufweist, und

$a_4$) 0 bis 40 Gew.% mindestens eines Hilfsstoffes, mit dessen Hilfe das Eigenschaftsprofil variiert wird, enthält.

Hierbei werden alle diejenigen Raumformen als "flächenförmig" bezeichnet, deren Dicke erheblich kleiner ist als ihre Länge und Breite. Demnach handelt es sich hier um band- oder um plattenförmige Aufzeichnungsmaterialien.

Diese Aufzeichnungsmaterialien werden dann als "lichtempfindlich" bezeichnet, wenn sie eine Schicht enthalten, in welcher bei der bildmäßigen Belichtung mit aktinischem Licht eine Lögslichkeitsdifferenzierung zwischen den belichteten und unbelichteten Bereichen eintritt, so daß die Schicht mit Entwicklern ausgewaschen, d.h. entwickelt werden kann. Folgerichtig werden diese sogenannten reliefbildenden Schichten (A) bei der vollflächigen Belichtung mit aktinischem Licht in den Entwicklern völlig unlöslich oder völlig löslich bzw. sehr leicht quellbar.

Eine reliefbildende Schicht (A) wird als "photopolymerisierbar" angesehen, wenn in ihr aufgrund ihrer stofflichen Zusammensetzung bei der bildmäßigen Belichtung mit aktinischem Licht die Photopolymerisation initiiert wird und abläuft. Dies hat eine Löslichkeitsdifferenzierung zwischen den belichteten und unbelichteten Bauten der Schicht (A) zur Folge, weswegen ihre unbelichteten Bereiche mit Entwicklern ausgewaschen (entwickelt) werden können.

Unter "Entwicklern" sind Flüssigkeiten zu verstehen, die in der Hauptsache ein Lösungsmittel oder ein Lösungsmittelgemisch enthalten. Darüber hinaus können diese Entwickler im allgemeinen Zusatzstoffe, wie feste, flüssige oder gasförmige, organische und anorganische Verbindungen enthalten. Sie dienen dem Entwickeln, d.h. dem Auswaschen der bildmäßig belichteten reliefbildenden Schicht (A). Voraussetzung dafür, daß eine bestimmte bildmäßig belichtete reliefbildende Schicht (A) mit einem bestimmten Entwickler ausgewaschen werden kann, ist vor allem die Löslichkeit oder Quellbarkeit des Bindemittels ($a_1$) in dem betreffenden Entwickler. Die Natur des Entwicklers läßt daher auch eindeutige Rückschlüsse auf die stoffliche Zusammensetzung der reliefbildenden Schicht (A) zu.

Der Begriff "verträglich" zeigt an, daß die betreffende Komponente in der reliefbildenden Schicht (A) molekulardispers verteilt werden kann, hierin keine Trübung hervorruft und sich auch im Laufe der Zeit nicht entmischt.

Unter "Variation des Eigenschaftsprofils" ist die gezielte Verbesserung bestimmter anwendungstechnischer Eigenschaften von photopolymerisierbaren reliefbildenden Schichten (A) und von hieraus hergestellten photopolymerisierten Reliefschichten (A') zu verstehen. Diese Verbesserungen machen sich vor allem bei photopolymerisierte Reliefschichten (A') enthaltenden Reliefplatten, Reliefdruckplatten und Photoresists bemerkbar und werden allgemein durch Zugabe üblicher und bekannter Zusatzstoffe zu den reliefbildenden Schichten (A) erzielt. Diese Zusatzstoffe werden daher als "Hilfsstoffe" bezeichnet.

Flächenförmige lichtempfindliche Aufzeichnungsmaterialien sind aus der DE-B-22 15 090, der DE-A-29 42 183, der DE-A-24 44 118, der DE-A-24 56 439 oder der DE-A-21 83 582 bekannt. Diese bekannten Aufzeichnungsmaterialien enthalten keine Ethylen-Propylen-Alkadien-Terpolymerisate, sondern andere Polymerisate als Bindemittel ($a_1$).

Die bekannten Aufzeichnungsmaterialien dienen der Herstellung von Reliefdruckplatten, insbesondere von Flexodruckplatten, durch bildmäßiges Belichten und Entwickeln ihrer photopolymerisierbaren reliefbildenden Schicht (A).

Die fertigen Flexodruckplatten werden vor allem für das Bedrucken von Folien, Wellpappe und Verpackungen herangezogen. Nachteilig ist, daß die Verwendung von Flexodruckplatten des Standes der Technik einer wesentlichen Einschränkung hinsichtlich der Auswahl der Druckfarben unterliegt.

Zur Verwendung kommen üblicherweise Druckfarben, die als Hauptkomponente neben den Farb- und Bindemitteln Lösungsmittel enthalten. Solche Lösungsmittel sind hauptsächlich Ethanol und Wasser. Um die Farbdeckung und die Trocknungsgeschwindigkeit bei nichtsaugenden Bedruckstoffen wie z.B. Polyethylenterephthalat-, Aluminium-, Polyvinylchlorid- oder Polyvinylidenchloridfolien oder Zellglas zu erhöhen, werden den Druckfarben sogenannte Beschleuniger zugesetzt, die hohe Verdunstungszahlen besitzen und/oder haftvermittelnd wirken. Vorzugsweise werden hier Essigester, n- und i-Propylaceteat, Aceton, Methylethylketon, Butanon oder Methylisobutylketon verwendet.

Die bekannten Flexodruckplatten sind jedoch gegenüber diesen Beschleunigern nur unzureichend beständig. So erfahren sie während des Druckens mit Druckfarben eines Keton- und/oder Esteranteils von mehr als 10 Gew.% eine Dicken- und Volumenzunahme, welche eine hohe Druckauflage verhindert. Für das Drucken mit solchen Druckfarben müssen deshalb in aller Regel sogenannte Gummiklischees verwendet werden. Diese Gummiklischees müssen nach den klassischen Abformmethoden durch Schneiden und/oder Heißpressen hergestellt werden, wobei oftmals auch noch ihre Rückseite abgeschliffen werden muß. Keinesfalls können hierbei die eleganten, exakten und zeitsparenden Belichtungs- und Entwicklungstechniken angewandt werden, was allein schon einen äußerst schwerwiegenden Nachteil darstellt. Hinzu kommt noch, daß diese Gummiklischees die Bildmotive nur ungenau wiedergeben, ihre Reliefs breite Flanken aufweisen und daß sie beim Drucken Tonwertverluste und Ausbrüche bei Rastern und freistehenden Punkten aufweisen.

Für die Herstellung dieser Gummiklischees werden oftmals Ethlyen-Propylen-Alkadien-Terpolymerisate verwendet, welche allgemein auch als "EPDM-Kautschuke" bezeichnet werden. Bei der Abformung der Gummiklischees werden diese EPDM-Kautschuke durch Schwefel oder Peroxide in der klassischen Weise chemisch vernetzt, d.h. vulkanisiert. Wegen ihrer optischen Eigenschaften sind sie für die eleganten, exakten und zeitsparenden Belichtungs- und Entwicklungstechniken, wie sie bei bekannten flächenförmigen lichtempfindlichen Aufzeichnungsmaterialen mit photopolymerisierbaren reliefbildenden Schichten (A) angewandt werden, völlig untauglich.

Aufgabe der vorliegenden Erfindung ist es, ein neues, flächenförmiges lichtempfindliches Aufzeichnungsmaterial mit einer photopolymerisierbaren reliefbildenden Schicht (A) zu finden, welches die Nachteile des Standes der Technik nicht mehr länger aufweist.

Demgemäß wurde das eingangs definierte, flächenförmige lichtempfindliche Aufzeichnungsmaterial I gefunden, welches im folgenden kurz als "erfindungsgemäßes Aufzeichnungsmaterial I" bezeichnet wird.

Wesentlicher Bestandteil des erfindungsgemäßen Aufzeichnungsmaterials I ist seine neue photopolymerisierbare reliefbildende Schicht (A).

Die neue photopolymerisierbare reliefbildende Schicht (A) enthält, bezogen auf (A), 20 bis 99,499 Gew.% mindestens eines polymeren Bindemittels $(a_1)$ aus der Gruppe der statistischen Ethylen-Propylen-Alkadien-Terpolymerisate eines Ethylengehalts von 40 bis 80 Gew.% und eines Doppelbindungsanteils von 2 bis 20 Doppelbindungen je 1000 Kohlenstoffatome.

Hierbei soll der Gehalt der neuen Schicht (A) an Ethylen-Propylen-Alkadien-Terpolymerisaten $(a_1)$ 99,499 Gew.% nicht überschreiten, weil ansonsten die Photopolymerisation in der neuen Schicht (A) nur noch sehr langsam abläuft und die hieraus resultierende Löslichkeitsdifferenzierung bei der bildmäßigen Belichtung den Anforderungen der Praxis nicht mehr genügt. Dagegen soll der Gehalt der neuen Schicht (A) an Ethlyen-Propylen-Alkadien-Terpolymerisaten $(a_1)$ 20 Gew.% nicht unterschreiten, weil ansonsten die mechanische Festigkeit der neuen Schicht (A) leidet.

Erfindungsgemäß von Vorteil ist ein Gehalt an Ethylen-Propylen-Alkadien-Terpolymerisaten $(a_1)$ von 25 bis 95, vorzugsweise 30 bis 90 und insbesondere 35 bis 85 Gew.%. Hierbei ist der Bereich von 35 bis 85 Gew.% hervorzuheben, weil die neue photopolymerisierbare reliefbildende Schicht (A) mit einem Gehalt an Ethylen-Propylen-Alkadien-Terpolymerisaten $(a_1)$ in diesem Bereich besonders vorteilhafte Eigenschaften hat. Eine weitere Steigerung resultiert, wenn der Gehalt bei 70 bis 83 Gew.% liegt. Dieser Gehalt der neuen Schicht (A) an Ethylen-Propylen-Alkadien-Terpolymerisaten stellt insbesondere dann das Optimum dar, wenn das betreffende erfindungsgemäße Aufzeichnungsmaterial I der Herstellung von Flexodruckplatten dient.

Die erfindungsgemäß zu verwendenden Ethylen-Propylen-Alkadien-Terpolymerisate $(a_1)$ haben einen Ethylengehalt von 40 bis 80 Gew.%. Hierbei soll der Ethylengehalt 80 Gew.% nicht überschreiten, weil ansonsten das betreffende Terpolymerisat $(a_1)$ wegen seiner physikalisch chemischen Eigenschaften weniger gut für den Aufbau der neuen Schicht (A) geeignet ist. Andererseits soll der Ethylengehalt 40 Gew.% nicht unterschreiten, weil sich ansonsten auch hierbei weniger gute anwendungstechnische Eigenschaften des betreffenden Terpolymerisats $(a_1)$ ergeben. Von Vorteil ist ein Ethylengehalt von 45 bis 75 Gew.%, weil die Ethylen-Propylen-Alkadien-Terpolymerisate $(a_1)$ dieses Ethylengehalts besonders vorzügliche polymere Bindemittel $(a_1)$ für die neue photopolymerisierbare reliefbildende Schicht (A) der erfindungsgemäßen Aufzeichnungsmaterialien I sind.

Die erfindungsgemäß zu verwendenden Ethylen-Propylen-Alkadien-Terpolymerisate $(a_1)$ haben einen Doppelbindungsanteil von 2 bis 20 olefinischen Doppelbindungen je 1000 Kohlenstoffatome. Der Doppelbindungsanteil resultiert aus dem Einpolymerisieren der Alkadiene bei der Herstellung der Terpolymerisate $(a_1)$. Die in den Terpolymerisaten $(a_1)$ enthaltenen olefinischen Doppelbindungen liegen in der Hauptkette der Ter-

EP 0 326 977 B1

polymerisate ($a_1$) und/oder in hierzu seitenständigen Gruppen vor. Unabhängig davon, ob die olefinischen Doppelbindungen in der Hauptkette oder in den hierzu seitenständigen Gruppen oder ob sie in unterschiedlicher Anzahl sowohl in den Hauptketten als auch in den hierzu seitenständigen Gruppen vorliegen, soll der Doppelbindungsanteil der Terpolymerisate ($a_1$) 2 olefinische Doppelbindungen je 1000 Kohlenstoffatome nicht unterschreiten und 20 olefinische Doppelbindungen nicht überschreiten: Wird nämlich der betreffende Doppelbindungsanteil unterschritten, resultieren photopolymerisierbare reliefbildende Schichten (A), welche bei der bildmäßigen Belichtung und der Entwicklung nur noch mäßige bis schlechte Reliefschichten (A') liefern. Wird dagegen der betreffende Doppelbindungsanteil überschritten, so erhält man photopolymerisierbare reliefbildende Schichten (A), welche bei der bildmäßigen Belichtung und der Entwicklung Reliefschichten (A') liefern, welche für den Flexodruck nicht mehr geeignet sind. Demnach stellt der Bereich von 2 bis 20 olefinischen Doppelbindungen je 1000 Kohlenstoffatome ein Optimum dar, innerhalb dessen der Doppelbindungsanteil, den Anforderungen entsprechend, gezielt variiert wird. Innerhalb dieses Bereichs ist derjenige von 4 bis 15 olefinischen Doppelbindungen je 1000 Kohlenstoffatomen hervorzuheben, weil hiermit ein ganz besonders vorteilhafter technischer Effekt erzielt wird.

Die erfindungsgemäß zu verwendenden Ethylen-Propylen-Alkadien-Terpolymerisate ($a_1$) enthalten mindestens ein einpolymerisiertes Alkadien. Geeignet sind alle Alkadiene, welche sich mit Ethylen und Propylen zu Terpolymerisaten nach den üblichen und bekannten Methoden der Ethylencopolymerisation umsetzen lassen. Hierbei sind Alka-1,4-diene wie Buta-1,4-dien, Isopren, Penta-1,4-dien, Hexa-1,4-dien, Hepta-1,4-dien, Dicyclopentadien oder Ethylidennorbornen vorteilhaft und Dicyclopentadien, trans-Hexa-1,4-dien und Ethylidennorbornen ganz besonders vorteilhaft.

Beispiele erfindungsgemäß ganz besonders bevorzugter Ethylen-Propylen-Alkadien-Terpolymerisate ($a_1$) sind

– Ethylen-Propylen-Dicyclopentadien-,
– Ethylen-Propylen-Ethylidennorbornen-,
– Ethylen-Propylen-trans-Hexa-1,4-dien-,
– Ethylen-Propylen-Dicyclopentadien-Ethylidennorbornen-,
– Ethylen-Propylen-Dicyclopentadien-trans-Hexa-1,4-dien-,
– Ethylen-Propylen-Ethylidennorbornen-trans-Hexa-1,4-dien- oder
– Ethylen-Propylen-Ethylidennorbornen-Dicyclopentadien-trans-Hexa-1,4-dien-Terpolymerisate ($a_1$),

welche 45 bis 75 Gew.% Ethylen und soviel der Alkadiene einpolymerisiert enthalten, daß sich ein Doppelbindungsanteil von 4 bis 15 olefinischen Doppelbindungen je 1000 Kohlenstoffatome ergibt.

Die vorstehend im Detail beschriebenen, erfindungsgemäß zu verwendenden Ethylen-Propylen-Alkadien-Terpolymerisate ($a_1$) sind an sich bekannt und werden nach den üblichen und bekannten Verfahren der Ethylencopolymerisation hergestellt.

Die neue photopolymerisierbare reliefbildende Schicht (A) enthält, bezogen auf (A), 0,001 bis 10, vorzugsweise 0,1 bis 7, vorteilhafterweise 0,2 bis 5 und insbesondere 0,3 bis 4 Gew.% eines oder mehrerer Initiatoren der Photopolymerisation (Photoinitiator) ($a_2$), wobei diese Menge mitbestimmt wird von der Menge an mitverwendeten Komponenten ($a_3$).

Beispiele geeigneter Photoiniatoren ($a_2$) sind Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethyl-acetal; oder Acylarylphosphinoxide, wie 2-Dimethoxibenzoyl-diphenylphosphinoxid, 2,4,6-Trimethylbenzoyl-diphenylphosphinoxid, 2,4,6-Trimethylbenzoyl-phenylphosphinsäureethylester oder 2,4,6-Trimethylbenzoyl-phenylphosphinsäure-Natrium-Salz oder substituierte oder unsubstituierte Chinone, wie Ethylanthrachinon, Benzathrachinon, Benzophenon oder 4,4'-Bis-(dimethylamino)benzophenon. Sie können allein oder im Gemisch miteinander oder in Verbindung mit Coinitiatoren verwendet werden, z.B. Ethylanthrachinon mit 4,4'-Bis-(dimethylamino)benzophenon, Benzoinmethylether mit Triphenylphosphin, Diacylphosphinoxide mit tertiären Aminen oder Acylarylphosphinoxide mit Benzildimethylacetal.

Die neue photopolymerisierbare reliefbildende Schicht (A) enthält, bezogen auf (A), 0,5 bis 50, vorteilhafterweise 0,5 bis 30, vorzugsweise 1 bis 20 und insbesondere 1 bis 15 Gew.% mindestens eines Monomeren, welches mit dem Bindemittel ($a_1$) verträglich ist und mindestens eine photopolymerisierbare olefinisch ungesättigte Doppelbindung aufweist.

Geeignete Monomere ($a_3$) haben im allgemeinen einen Siedepunkt von über 100°C bei Atmosphärendruck und ein Molgewicht von bis zu 3000, insbesondere von bis zu 2000. Im allgemeinen handelt es sich bei den geeigneten Monomeren ($a_3$) um Ester der Acrylsäure und der Methacrylsäure, um Styrol und dessen Derivate, um Ester der Fumarsäure und der Maleinsäure, um Acryl- und Methacrylamide und um Allylverbindung. Voraussetzung für ihre Verwendbarkeit ist, daß sie die anspruchsgemäße Bedingung der Verträglichkeit mit dem Bindemittel ($a_1$) erfüllen.

Beispiele besonders gut geeigneter Monomerer ($a_3$), welche einen besonders vorteilhaften Effekt zur Fol-

4

gehaben, sind Isobornylacrylat, Isobornylmethacrylat, Dihydrodicyclopentadienylacrylat, Dihydrodicyclopentadienylmethacrylat, Hex-1-en-6-yl-acrylat, Hex-1-en-6-yl-methacrylat, Dihydroxylimonendiacrylat, Dihydroxylimo-nendimethacrylat, Dicyclopentyldimethylendiacrylat, Dicyclopentyldimethylendimethacrylat, Thio-diethyleng-lykoldiacrylat, Thio-diethylenglykol-dimethacrylat, Benzylacrylat, Benzylmethacrylat, Dodecandiol-diacrylat, Dodecandiol-dimethacrylat, Fumarsäure-di-n-butylester, Fumarsäure-di-n-octylester, Divinylbenzol, Diallylphthalat oder Itaconsäurebisallylester.

Die neue photopolymerisierbare reliefbildende Schicht (A) kann einen oder mehrere Hilfsstoffe enthalten, mit deren Hilfe das anwendungstechnische Eigenschaftsprofil der neuen Schicht (A) der erfindungsgemäßen Aufzeichnungsmaterialien I und der hieraus hergestellten Reliefdruckplatten und Photoresists variiert werden kann.

Hierbei handelt es sich vor allem um Weichmacher, Inhibitoren der thermisch initiierten Polymerisation, Farbstoffe, Pigmente, photochrome Zusätze, Mittel zur Verbesserung der Reliefstruktur, Vernetzungshilfsmittel, Antioxidanten, Antiozonantien, Füllstoffe, Flußmittel oder Formtrennmittel. Ihre Menge soll 40 Gew.% der neuen Schicht (A) nicht überschreiten.

Beispiele für Weichmacher sind modifizierte und unmodifizierte Naturöle und -harze, wie paraffinische oder naphthenische Öle sowie Erdölharze oder Pentaerythritolester von hydriertem Kollophonium; Alkyl-, Alkenyl-, Arylalkyl- oder Arylalkenylalkoholester von Säuren, wie Zitronensäure, Essigsäure, Propionsäure, Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze, wie Oligostyrol, oligomere Styrol-Butadien-Copolymerisate, Oligo-$\alpha$-methylstyrol, oligomere $\alpha$-Methylstyrol/p-Methylstyrol-Copoly-merisate, flüssige 1,2- oder 1,4-Oligobutadiene, Oligopentadiene oder flüssige oligomere Acrylnitril-Butadien-Copolymerisate; sowie Polyterpen-, Polyacrylat-, Polyester- oder Polyurethanharze; synthetische Polymere, wie Polyethylen oder Ethylen-Propylen-Dien-Kautschuke; $\omega$-Methyl-oligo(ethylenoxid); oder Sulfonamide.

Beispiele besonders gut geeigneter Weichmacher sind die paraffinische Mineralöle; die Ester von Dicarbonsäuren wie Dioctyladipat oder Terephthalsäuredioctylester; die naphthenischen Weichmacher, vorzugsweise mit einem Aromatengehalt < 20 % und/oder einem Schwefelgehalt > 5 %; Polyoctenamere im Molgewichtsbereich 1000 - 1,2·$10^5$, wobei man unter Polyoctenameren bekanntermaßen Macrocyclen aus Poly(octenylen) versteht; oder Polybutadiene mit einem Molgewicht zwischen 500 - 5000, vor allem solche mit einem Vinylgruppengehalt > 50 %. Gegebenenfalls können sowohl die Polyoctenamere als auch die Polybutadiene funktionelle bzw. reaktive Endgruppen enthalten, wie z.B. COOH-, OH-, $NH_2$-, Carbonsäureanhydrid- oder Acrylat-Gruppen. Von Vorteil sind Mengen von 1 bis 25 Gew.%, bezogen auf die Schicht (A).

Inhibitoren der thermisch initiierten Polymerisation werden im allgemeinen in einer Menge von 0,001 bis 2 Gew.%, bezogen auf die neue Schicht (A), zugesetzt. Sie weisen im allgemeinen keine nennenswerte Eigenabsorption in dem aktinischen Bereich auf, in dem der Photoinitiator ($a_2$) absorbiert. Beispiele für Inhibitoren sind Hydrochinon, p-Methoxiphenol, 2,6-Di-tert.-butyl-p-kresol, ß-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium, Calcium- oder Aluminiumsalze, des N-Nitrosocyclohexylhydroxylamins.

Farbstoffe, Pigmente oder photochrome Zusätze können den neuen Schichten (A) in einer Menge von 0,0001 bis 2 Gew.%, bezogen auf (A), zugesetzt werden. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist es, daß sie - ebenso wie die Inhibitoren der thermisch initiierten Polymerisation - die Photopolymerisation der Gemische nicht stören. Geeignet sind z.B. die löslichen Phenazinium-, Phenoxazinium-, Acridinium und Phenothiaziniumfarbstoffe. Diese Farbstoffe werden auch zusammen mit einer hinreichenden Menge eines Reduktionsmittels verwendet, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexylhydroxylamins, vorzugsweise die Kalium-, Calcium- und Aluminiumsalze. Letztere können, wie erwähnt, zugleich als Inhibitoren der thermisch initiierten Polymerisation dienen.

Die Reduktionsmittel werden im allgemeinen in Mengen von 0,005 bis 5 Gew.%, bezogen auf die neue Schicht (A), zugesetzt, wobei sich in vielen Fällen der Zusatz eines 3- bis 10fachen der Menge an mitverwendetem Farbstoff bewährt hat.

Beispiele für Vernetzungshilfsmittel sind die üblichen und bekannten tri- und tetrafunktionellen Thiolverbindungen.

Beispiele für Antioxidanten sind sterisch gehinderte Monophenole, wie 2,6-Di-tert.-butyl-p-kresol; alkylierte Thiobis- und Alkylidenbisphenole, wie 2,2′-Methylen-bis-(4-methyl-6-tert.-butylphenol) oder 2,2′-Bis-(1-hydroxy-4-methyl-6-tert.-butylphenyl)sulfid; Hydroxybenzyle, wie 1,3,5-Trimethyl-2,4,6-tris-(3,5-di-tert.-butyl-4-hydroxybenzyl)benzol; Triazine, wie 2-(4-Hydroxy-3,5-tert.-butylanilino)-4,6-bis-(n-octylthio)-1,3,5-triazin; polymerisiertes Trimethyldihydrochinon; Zinkbutyldithiocarbamat; Dilaurylthiodipropionat; oder Phosphite, wie Tris(nonylphenyl)phosphit. Von Vorteil sind Mengen 0,0001 bis 5 Gew.%, bezogen auf die neue Schicht (A).

Beispiele für nicht molekulardispers einmischbare, polymere oder nicht polymere organische und anorganische Füllstoffe oder Verstärkungsfüllstoffe sind solche, die für die Wellenlängen des zur Belichtung der erfindungsgemäßen Aufzeichnungsmaterialien I verwendeten Lichts im wesentlichen durchlässig sind, dieses Licht nicht streuen und in ihrem Brechungsindex weitgehend dem betreffenden erfindungsgemäßen Aufzeichnungsmaterial I bzw. der betreffenden neuen Schicht (A) angepaßt sind, wie etwa Polystyrol, organophiles Siliciumdioxid, Bentonit, Kieselsäure, ®Aerosil, organophiles Aluminiumoxid, Glaspulver, kolloidaler Kohlenstoff sowie verschiedene Arten von Farbstoffen und Pigmenten. Diese Hilfsstoffe werden in Mengen verwendet, die mit den gewünschten Eigenschaften der erfindungsgemäßen Aufzeichnungsmaterialien I variieren. Die Füllstoffe haben den Vorteil, daß sie die Festigkeit der neuen, photopolymerisierbaren reliefbildenden Schichten (A) und der hieraus hergestellten Reliefschicht (A′) sowie deren Abriebfestigkeit weiter verbessern, deren Klebrigkeit - sofern vorhanden - verringern und unter Umständen hierin als farbgebende Mittel wirksam sind.

Ein Beispiel für ein Flußmittel ist Calciumstearat.

Ein Beispiel für ein Formtrennmittel ist Talkum.

Beispiele für Antiozonantien sind die üblichen und bekannten Ozonschutzwachse sowie die Chloralkane (Chlorparaffine) mit 8 bis 40 Kohlenstoffatomen und 30 bis 73 Gew.% Chlor im Molekül.

Beispiele für Mittel zur Verbesserung der Reliefstruktur der aus den erfindungsgemäßen Aufzeichnungsmaterialien I hergestellten Reliefdruckplatten sind beispielsweise 9,9′-Dianthronyl und 10,10′-Bisanthron.

Die Dicke der neuen photopolymerisierbaren reliefbildenden Schicht (A) richtet sich in erster Linie nach dem Verwendungszweck der erfindungsgemäßen Aufzeichnungsmaterialien I: So variiert die Dicke im allgemeinen von 0,001 bis 7, vorzugsweise 0,1 bis 7 und insbesondere 0,7 bis 6,5 mm, weil die erfindungsgemäßen Aufzeichnungsmaterialien I, welche neue Schichten (A) dieser Dicke aufweisen, für die Mehrzahl der Drucktechniken sowie für die Photoresisttechnik geeignet sind.

Außer der neuen photopolymerisierbaren reliefbildenden Schicht (A) kann das erfindungsgemäße Aufzeichnungsmaterial I weitere Schichten oder flächenförmige Gebilde enthalten, welche für seine Funktion von Nutzen sind.

So kann die neue photopolymerisierbare reliefbildende Schicht (A) mit einem dimensionsstabilen Träger (B) haftfest oder leicht ablösbar verbunden sein. Der dimensionsstabile Träger (B) wiederum kann mit einer weichelastischen Unterschicht (US) unterlegt sein. Ferner kann eine haftfeste Verbindung zwischen dem Träger (B) und der neuen Schicht (A) mit Hilfe einer Haftschicht (HS) erreicht werden. Sofern der Träger (B) mit der neuen Schicht (A) leicht ablösbar verbunden ist, wird er auch als temporärer Schichtträger (B) bezeichnet.

Als dimensionsstabile Träger (B) können Platten, Folien oder konische oder zylindrische Röhren (sleeves) aus Metallen, wie Stahl, Aluminium, Kupfer oder Nickel oder aus Kunststoffen, wie Polyethylenterephthalat, Polybutylenterephthalat, Polyamid oder Polycarbonat verwendet werden. Daneben kommen noch Gewebe und Vliesse, z.B. Glasfasergewebe oder Verbundmaterialien aus z.B. Glasfasern und Kunststoffen wie Polyethylenterephthalat in Frage. Daneben kommen als Träger (B) auch Platten in Betracht, wie sie üblicherweise bei der Herstellung von Leiterplatten verwendet werden.

Als Haftschichten (HS) werden mit Vorteil übliche und bekannte, etwa 0,5 bis 40 μm dicke Haftlackschichten verwendet.

Werden als Träger (B) stark reflektierende Platten oder Folien verwendet, dann können sie geeignete Lichthofschutzmittel, wie Ruß oder Mangandioxid enthalten. Die Lichthofschutzmittel können aber auch als separate Schicht auf dem Träger (B) aufgetragen werden oder in der Haftschicht (HS) oder in der neuen Schicht (A) enthalten sein.

Außerdem kann das erfindungsgemäße Aufzeichnungsmaterial I eine lichtdurchlässige, in den Entwicklern für die neue Schicht (A) lösliche oder quellbare, glatte oder mattierte, nicht klebrige Deckschicht (C) enthalten, welche an der neuen Schicht (A) fester haftet als an einer gegebenenfalls vorhandenen Deckfolie (D) und welche von einem reißfeste Filme bildenden Polymeren und den gegebenenfalls darin enthaltenen Zusatzstoffen gebildet wird.

Beispiele geeigneter, reißfeste Filme bildender Polymere sind Polyamide, Copolyamide, Polyurethane, Poly(meth)acrylate, Polyvinylalkohol-alkancarbonsäureester eines Hydrolysegrades von 30 bis 99 %, Cyclokautschuke hohen Cyclisierungsgrades, Ethylen/Propylen-Copolymerisate, Homo- und Copolymerisate des Vinylchlorids oder Ethylen/Vinylacetat-Copolymerisate.

Beispiele geeigneter Deckschichten (C), welche Zusatzstoffe enthalten, sind aus der US-A-4 162 919, der DE-A-28 23 300, der DE-B-21 23 702, der US-A-4 072 527 oder der US-A-3 453 311 bekannt.

EP 0 326 977 B1

Beispiele besonders gut geeigneter Deckschichten (C), welche Zusatzstoffe enthalten, werden in der deutschen Patentanmeldung P 37 32 527.2 (O.Z. 0050/39458) beschrieben.

Im allgemeinen sind die Deckschichten 0,2 bis 25 µm dick.

Desweiteren kann das erfindungsgemäße Aufzeichnungsmaterial I eine Deckfolie (D) enthalten, welche sich von der neuen photopolymerisierbaren reliefbildenden Schicht (A) oder von der Deckschicht (C) leicht ablösen läßt.

Die Deckfolien (D) sind 10 bis 250, insbesondere 20 bis 150 µm dick. Sie bestehen im wesentlichen aus Kunststoffen, textilen Stoffen, Papieren oder Metallen. Diejenige Oberfläche der Deckfolien (D), welche der Deckschicht (C) unmittelbar aufliegt, ist glatt, d.h., sie weist einen Oberflächenrauhwert $R_{max} \leq 0,1$ µm auf, oder sie ist mattiert, d.h., sie hat einen Oberflächenrauhwert $R_{max}$ zwischen 0,1 und 15, vorzugsweise 0,3 bis 10, und insbesondere 0,5 bis 7 µm. Sofern die Deckfolie (D) mattiert ist, prägt sich ihr Rauhheitsmuster in die Deckschicht (C) und ggf. auch noch in die Oberfläche der neuen Schicht (A) ein. Diese glatte oder matte Oberfläche der Deckfolie (D) kann außerdem antihaftend ausgerüstet sein, d.h., sie kann beispielsweise eine 0,1 bis 0,5 µm dicke Antihaftschicht (AS) aus üblichen und bekannten Silikonen oder aus anderen Kunststoffen, wie etwa Polyethylen oder Polypropylen aufweisen. Deckschichten (D) aus textilen Stoffen oder Papieren können zudem mit Kunststoffen wie Harnstofformaldehyd oder Polyolefinen imprägniert sein. Deckschichten (D) aus Kunststoffen können überdies biaxial gereckt sein. Hierbei ist es oftmals von Vorteil, vor der biaxialen Reckung eine 0,1 bis 0,5 µm dicke Schicht aus beispielsweise einem Vinylidenchloridcopolymerisat auf derjenigen Seite von (D) aufzutragen, welche später (C) oder der neuen Schicht (A) direkt aufliegt.

Beispiele besonders vorteilhafter Deckfolien (D) sind 20 bis 150 µm dicke, glatte oder mattierte, biaxial gereckte oder ungereckte, ggf. antihaftend ausgerüstete Kunststoffolien aus Polyethylen, Polypropylen, Polyamid, Polystyrol, Styrol/Acrylnitril-Copolymerisaten oder aus Polymethylmethacrylat; oder aus Copolymerisaten von Methylmethacrylat mit Methacrylsäure, Acrylsäure, Methylacrylat oder mit Butylacrylat; oder aus Polyvinylchlorid, Polyvinylacetat, Vinylchlorid/Vinylacetat-Copolymerisaten, Polyvinylalkohol, Polyvinylpyrrolidon, Polycarbonat, Celluloseester, wie etwa Celluloseacetatsuccinat, oder aus Polyethylenterephthalat, von denen Deckfolien (D) aus Polyethylenterephthalat ganz besonders vorteilhaft sind.

Die Herstellung des erfindungsgemäßen Aufzeichnungsmaterials I weist keine technischen Besonderheiten auf, sondern erfolgt nach den üblichen und bekannten Methoden der Herstellung lichtempfindlicher Schichten und Deckschichten sowie nach den üblichen und bekannten Methoden der Herstellung von Folien aus Kunststoffen, textilen Stoffen, Papieren oder Metallen.

So werden die neuen photopolymerisierbaren reliefbildenden Schichten (A) üblicherweise durch das Mischen der vorstehend beschriebenen Komponenten $(a_1)$, $(a_2)$, $(a_3)$ und gegebenenfalls $(a_4)$ mittels der üblichen Knet-, Misch- und Lösungstechniken und durch Formen der hierbei resultierenden Gemische (A) zu flächenförmigen neuen Schichten (A) mittels Gießen aus Lösung, Heißpressen, Kalandrieren oder Extrudieren hergestellt. Sofern die erfindungsgemäßen Aufzeichnungsmaterialen I lediglich aus der neuen Schicht (A) bestehen, ist mit deren Herstellung das Herstellverfahren insgesamt abgeschlossen.

Enthalten die erfindungsgemäßen Aufzeichnungsmaterialien I weitere Schichten oder flächenförmige Gebilde, sind weitere Arbeitsgänge durchzuführen, welche in das Verfahren zur Herstellung der mehrschichtigen erfindungsgemäßen Aufzeichnungsmaterialien I integriert sind oder separat hiervon durchgeführt werden.

So wird die Deckschicht (C) üblicherweise nach den Methoden hergestellt, wie sie auch für die Darstellung der neuen Schicht (A) in Betracht kommen.

Die Bestandteile der Deckfolien (D) werden gleichfalls mittels der üblichen Knet-, Misch- und Lösungstechniken vermengt und durch Gießen aus Lösung, Heißpressen, Kalandrieren oder Extrudieren und Blasformen zu den entsprechenden Folien geformt. Auch diese Arbeitsgänge können in das Verfahren zur Herstellung der erfindungsgemäßen Aufzeichnungsmaterialien integriert sein, üblicherweise werden indes die Deckfolien (D) separat hergestellt, auf Rollen aufgewickelt und in dieser Form für die Herstellung der mehrschichtigen erfindungsgemäßen Aufzeichnungsmaterialien I angewendet.

Auch die Herstellung der mehrschichtigen erfindungsgemäßen Aufzeichnungsmaterialien I weist keine technischen Besonderheiten auf, sondern erfolgt in üblicher Weise durch Verbinden der neuen photopolymerisierbaren reliefbildenden Schicht (A) mit der Deckschicht (C) und der Deckfolie (D), wobei dies auch auf einem dimensionsstabilen Träger (A) ggf. unter Mitverwendung einer Haftschicht (HS) und einer weichelastischen Unterschicht (US) erfolgen kann. Hierbei ist es grundsätzlich möglich, die neue Schicht (A) zuerst mit dem Träger (B) zu verbinden und anschließend ihre unbedeckte Seite mit der Deckschicht (C) und der Deckfolie (D) zu bedecken, oder aber die neue Schicht (A) wird zunächst auf die mit der Deckschicht (C) überzogene Deckfolie (D) aufgetragen und dann erst mit dem Träger (B) verbunden. Selbstverständlich können diese Arbeitsgänge in üblichen und bekannten, kontinuierlich oder diskontinuierlich arbeitenden Anlagen hintereinander oder gleichzeitig ausgeführt werden.

In allen Fällen kann die neue, photopolymerisierbare reliefbildende Schicht (A) aus neuen photopolymeri-

7

sierbaren Teilschichten (A) aufgebaut werden. Diese neuen Teilschichten (A) können von gleicher, in etwa gleicher oder von unterschiedlicher stofflicher Zusammensetzung sein. Die Herstellung der neuen, aus Teilschichten (A) aufgebauten Schicht (A) kann nach der in der EP-A-0 084 851 angegebenen Methode erfolgen.

Die erfindungsgemäßen, gegebenenfalls mehrschichtigen Aufzeichnungsmaterialien I weisen besondere Vorteile auf: So sind sie mittels der üblichen und bekannten Methoden herzustellen und erfordern somit keine Umbauten bereits vorhandener Anlagen und Apparaturen oder gar Neuinvestitionen in neue, speziell zu entwickelnde Anlagen und Apparaturen. Sie sind dimensionsstabil und neigen nicht zum kalten Fließen oder zum Ausschwitzen darin enthaltener Komponenten. Sie können daher bedenkenlos transportiert und längere Zeit gelagert werden, ohne daß es hierbei zu einer Beschädigung kommt.

Die besonderen Vorteile der erfindungsgemäßen, gegebenenfalls mehrschichtigen Aufzeichnungsmaterialien I treten bei ihrer Verwendung für die Herstellung von Reliefdruckplatten und Photoresists, insbesondere aber von Flexodruckplatten, in überzeugender Weise zu Tage. Dabei umfaßt die Herstellung der Reliefdruckplatten und Photoresists aus den erfindungsgemäßen, ggf. mehrschichtigen Aufzeichnungsmaterialien I üblicherweise die folgenden Arbeitsgänge:

(i) ggf. Vorbehandeln der erfindungsgemäßen Aufzeichnungsmaterialien I,

(ii) ggf. Ablösen der Deckfolie (D) von der ggf. vorhandenden Deckschicht (C),

(iii) Auflegen einer Bildmaske oder Negativvorlage auf die neue Schicht (A) oder auf die ggf. vorhandene Deckschicht (C),

(iv) bildmäßiges Belichten der neuen photopolymerisierbaren reliefbildenden Schicht (A) mit aktinischem Licht einer Wellenlänge $\lambda$ zwischen 230 und 450, insbesondere 350 und 450 nm,

(v) Auswaschen (Entwickeln) der unbelichteten Bereiche der bildmäßig belichteten reliefbildenden Schicht (A) mittels geeigneter organischer Entwickler, wobei auch die ggf. vorhandene Deckschicht (C) weggewaschen wird, und

(vi) Trocknen sowie

(vii) ggf. Nachbehandeln der in dieser Weise erhaltenen Reliefdruckplatten und Photoresists, welche nun die neue Reliefschicht (A') enthalten oder aus dieser bestehen.

Die Dicke der neuen Reliefschicht (A') variiert je nach Anwendungszweck der Reliefdruckplatten und Photoresists von 0,001 bis 7, vorzugsweise 0,1 bis 7 und insbesondere 0,7 bis 6,5 mm.

Eine übliche Methode der Vorbehandlung ist die vollflächige Belichtung der neuen Schicht (A) von ihrer Rückseite her mit aktinischem Licht. Unter Rückseite ist hierbei die Seite zu verstehen, welche der später gebildeten neuen Reliefschicht (A') abgewandt ist.

Geeignete Lichtquellen für aktinisches Licht sind handelsübliche UV-Fluoreszenzröhren, Quecksilbermittel-, -hoch- und -niederdruckstrahler, superaktinische Leuchtstoffröhren, Xenon-Impulslampen, mit Metalliodiden dotierten Lampen oder Kohlebogenlampen.

Beispiele geeigneter organischer Entwickler sind aliphatische oder aromatische Kohlenwasserstoffe, wie n-Hexan, n-Heptan, Octan, Petrolether, Ligroin, Limonen oder andere Terpene, Toluol, Xylol, Ethylbenzol oder Isopropylbenzol oder Gemische aus diesen Lösungsmitteln; Ketone, wie Aceton oder Methylethylketon; Ether, wie Di-n-butylether; Ester, wie Essigsäureethylester oder Acetessigsäureethylester; halogenierte aliphatische Kohlenwasserstoffe, wie Methylenchlorid, Chloroform, Trichlorethane, Tetrachlorethylen, Dichlortetrafluorethane oder Trichlortrifluorethane; oder Gemische, die zwei oder mehr dieser Lösungsmittel enthalten; oder Gemische, die eines oder mehrere dieser Lösungsmittel und zusätzlich noch Alkohole, wie Methanol, Ethanol, Isopropanol oder n-Butanol enthalten; oder Lösungsmittel und Gemische der genannten Art, die zusätzlich feste, flüssige oder gasförmige organische und anorganische Verbindungen, wie etwa Tenside, in untergeordneten Mengen enthalten.

Übliche Methoden der Nachbehandlung der neuen Reliefschicht (A') sind das vollflächige Nachbelichten mit aktinischem Licht einer Wellenlänge $\lambda$ zwischen 150 und 450 nm, das Nachbelichten mit sichtbarem Licht oder das Behandeln mit halogenhaltigen Lösungen.

Werden die erfindungsgemäßen, ggf. mehrschichtigen Aufzeichnungsmaterialien I diesem Verfahren unterzogen, erweisen sie sich als

– rasch belichtbar, wobei ihr Belichtungsspielraum ausgesprochen groß ist,

– detailgetreu in der Wiedergabe auch der feinsten und daher kritischen Bildmotive der Bildmasken oder Negativvorlagen und als

– ausgesprochen auswaschstabil, so daß die Entwicklungsbedingungen zwecks Verkürzung der Entwicklungszeiten bedenkenlos verschärft werden können.

Dadurch verkürzen sich die Taktzeiten bei der Herstellung von Reliefdruckplatten und Photoresists, was für die betriebliche Praxis ein erheblicher Vorteil ist. Dieser Vorteil fällt insbesondere bei der Herstellung von Flexodruckplatten ins Gewicht.

Die besonderen Vorteile der erfindungsgemäßen Aufzeichnungsmaterialien I sind damit nicht erschöpft, sondern sie manifestieren sich besonders überzeugend in den Reliefdruckplatten und den Photoresists, welche man in der vorstehend beschriebenen Weise hergestellt hat:

So können die neuen Photoresists mit Vorteil für die Herstellung von Leiterplatten verwendet werden, und die neuen Reliefdruckplatten, insbesondere die neuen Flexodruckplatten, lassen sich auf Druckzylinder aufbringen und in dieser Form hervorragend für den Endlosdruck verwenden.

Zu diesem Zweck müssen die neuen Flexodruckplatten - im Gegensatz zu denen des Standes der Technik - nicht mit halogenhaltigen Lösungen nachbehandelt werden, weil sie auch so bereits eine gleichmäßig matte und klebfreie Oberfläche haben.

Während des Druckens auf einem üblichen und bekannten Flexodruckwerk zeigen sie eine ausgeprägte Stabilität gegenüber Druckfarben, die Ester und/oder Ketone enthalten. Hinzu kommt noch, daß die neuen Flexodruckplatten deutlich stabiler gegenüber Ozon sind als die Flexodruckplatten des Standes der Technik, so daß mit Hilfe der neuen Flexodruckplatten exzellente Druckerzeugnisse in hoher Auflage erhalten werden. Darüber hinaus können die neuen Flexodruckplatten mehrfach wiederverwendet werden, ohne daß die Qualität der Druckerzeugnisse hierbei leidet. Zu diesem Zweck können die neuen Flexodruckplatten entweder auf den Druckzylindern aufgespannt gelagert werden oder sie können ohne Bedenken mehrfach von den Druckzylindern abgelöst, gelagert und hiernach erneut auf die Druckzylinder aufgespannt werden, wobei das in der deutschen Patentanmeldung P 37 12 070.0 (O.Z. 0050/39107) beschriebene Verfahren zum Verbinden der zugeschnittenen Kanten von Flexodruckplatten mit besonderem Vorteil angewandt werden kann.

Beispiele

Beispiele 1 bis 8

Die Herstellung erfindungsgemäßer Aufzeichnungsmaterialien I und ihre Weiterverarbeitung zu neuen Flexodruckplatten.

Allgemeine Versuchsvorschrift:

Für die Herstellung der neuen photopolymerisierbaren reliefbildenden Schicht (A) wurde das Bindemittel $(a_1)$ gleichmäßig in einen Zweischneckenentgasungsextruder eingetragen und bei 140 bis 160°C aufgeschmolzen. Die flüssigen oder gelösten Komponenten $(a_2)$, $(a_3)$ und $(a_4)$ der neuen Schicht (A) wurden nacheinander in den Extruder gepumpt und dort mit der Schmelze des Bindemittels $(a_1)$ vermischt. Das hierbei resultierende lichtempfindliche Gemisch (A) wurde aus einer Breitschlitzdüse ausgetragen und von dort direkt in den Spalt eines Kalanders geleitet, wo es zu einer 2900 µm dicken neuen Schicht (A) geformt und zugleich auf seiner einen Seite mit einer 5 µm dicken Deckschicht (C) aus Polyamid und einer mattierten 125 µm dicken Polyethylenterephthalatfolie (Deckfolie D) und auf seiner anderen Seite mit einer 125 µm dicken Polyethylenterephthalatfolie als temporärem Schichtträger (B) verbunden wurde.

Dem hierbei resultierenden, erfindungsgemäßen mehrschichtigen Aufzeichnungsmaterial I des Aufbaus "(B), (A), (C) und (D)" wurden Proben entnommen, welche der Durchführung der nachstehend aufgeführten Tests dienten.

Der überwiegende Anteil des erfindungsgemäßen mehrschichtigen Aufzeichnungsmaterials wurde während 1 Minute von seiner Rückseite her durch den Träger (B) hindurch in einem Röhrenbelichter mit aktinischem Licht vollflächig belichtet. Hiernach wurden sowohl der Träger (B) von der Schicht (A) als auch die Polyethylenterephthalatfolie (D) von der Deckschicht (C) abgezogen.

Nach dieser Vorbehandlung wurde das erfindungsgemäße mehrschichtige Aufzeichnungsmaterial I durch eine übliche und bekannte, auf die Deckschicht (C) aufgelegte Testnegativvorlage hindurch während 55 Minuten in einem Flachbelichter® Cyrel 3040-115W mit aktinischem Licht bildmäßig belichtet und hiernach binnen 8 Minuten in einem Bürstenwascher mit Perchlorethylen entwickelt.

Die so erhaltene neue Flexodruckplatte wurde während 1 Stunde bei 65°C getrocknet und nach fünfzehnstündiger Lagerung während 20 Minuten vollflächig mit aktinischem Licht nachbelichtet, ohne daß diesem Verfahrensschritt die Nachbehandlung mit einer halogenhaltigen Lösung vorausgegangen wäre.

Die Tabelle 1 gibt Auskunft über die stoffliche Zusammensetzung der neuen photopolymerisierbaren reliefbildenden Schichten (A) der erfindungsgemäßen Aufzeichnungsmaterialien I-1 bis I-8 (Beispiele 1 bis 8), welche nach dieser allgemeinen Vorschrift hergestellt wurden.

Testvorschriften:

Die den erfindungsgemäßen mehrschichtigen Aufzeichnungsmaterialien I-1 bis I-7 (Tabelle 1, Beispiele 1 bis 7) entnommenen Proben dienten der Bestimmung der Ozonresistenz, der Shore A-Härte und der Quellbeständigkeit (Beispiele 1 bis 8) sowie der Reißdehnung, der Reißkraft und der sogenannten "Minidefo" (Beispiele 1 bis 3).

Hierbei wurden die Shore A-Härte nach DIN 53505 und die Reißdehnung (%) und die Reißkraft ($N/mm^2$) nach DIN 53504 in üblicher und bekannter Weise an vollflächig belichteten Teststreifen oder Proben der jeweils erforderlichen Abmessungen ermittelt.

Zur Bestimmung der sogenannten "Minidefo" wurde eine vollflächig belichtete Probe von mindestens 6 mm Stärke über einen Stempel des Durchmessers 4 mm mit einem Gewicht von 1 kg eine Minute lang belastet, wonach die hierdurch resultierende Dicke der Probe in der Eindruckstelle gemessen wurde (Angabe : Dicke in % der Anfangsdicke = % Belastung). Hiernach wurde das Gewicht entfernt, und es wurde nach einer Wartezeit von zwei Minuten wiederum die Dicke in der Eindruckstelle bestimmt (Angabe : Dicke in % der Anfangsdicke = % Entlastung). Hierbei ist der erste Wert (% Belastung) ein Maß für die Elastizität und die Plastizität der Probe, wogegen der zweite Wert (% Entlastung) ein Maß der Plastizität allein ist.

Als Maß der Quellbeständigkeit diente die Gleichgewichtsquellung (%) 2 cm breiter und 10 cm langer, vollflächig belichteter Teststreifen nach 24-stündiger Lagerung in Flexodruckfarbenlösungsmitteln.

Zur Prüfung der Stabilität gegenüber Ozon wurden 2 cm breite Teststreifen jeweils 10 Minuten lang einseitig belichtet, während 6 Minuten mit einem Gemisch aus Tetrachlorethylen und n-Butanol (Volumenverhältnis = 4:1) behandelt, während 1 Stunde bei 80°C getrocknet, 15 Stunden lang bei Raumtemperatur gelagert und während 10 Minuten nachbelichtet. Die so hergestellten Streifen konnten demnach als Modelle für Flexodruckplatten angesehen werden.

Die Streifen wurden unter 10 %iger Dehnung in einer Ozonkammer bei 24°C einer Luft mit einem Ozongehalt von 50 pphm ausgesetzt. Das Maß für die Ozonresistenz war die Zeit, nach welcher die ersten Ozonrisse an den Streifen auftraten.

Desweiteren wurden die nach der allgemeinen Vorschrift hergestellten, neuen Flexodruckplatten I-1 bis I-8 (Tabelle 1, Beispiele 1 bis 8) auf Druckzylinder aufgespannt und in dieser Form auf einem üblichen und bekannten Flexodruckwerk unter Verwendung üblicher und bekannter, Ketone und/oder Essigester enthaltender Flexodruckfarben zu Druckzwecken verwendet. Das Maß der Qualität der neuen Flexodruckplatten war die Höhe der Auflage an exzellenten Drucken.

Die erhaltenen Testergebnisse finden sich in der Tabelle 2. Sie belegen, daß die erfindungsgemäßen Aufzeichnungsmaterialien I ein hervorragendes anwendungstechnisches Eigenschaftsprofil aufweisen und insbesondere ozonresistent und quellbeständig sind.

Vergleichsversuche V1 und V2

Die Herstellung und Weiterverarbeitung bekannter lichtempfindlicher Aufzeichnungsmaterialien.

Gemäß der bei den Beispielen 1 bis 8 angegebenen allgemeinen Versuchsvorschrift wurden zwei bekannte lichtempfindliche Aufzeichnungsmaterialien hergestellt. Ihre Zusammensetzung wird in der Tabelle 1 (Vergleichsversuche V1 und V2) der Zusammensetzung der erfindungsgemäßen Aufzeichnungsmaterialien I-1 bis I-8 (Beispiele 1 bis 8) gegenübergestellt.

Die Eigenschaften der bekannten lichtempfindlichen Aufzeichnungsmaterialien (Vergleichsversuche V1 und V2) wurden gemäß den bei den Beispielen 1 bis 8 aufgeführten Testvorschriften ermittelt. Die Ergebnisse dieser Vergleichstests werden in der Tabelle 2 mitaufgeführt.

Der Vergleich zwischen den Eigenschaften der erfindungsgemäßen Aufzeichnungsmaterialien I-1 bis I-8 (Tabelle 2, Beispiele 1 bis 8) und denjenigen der bekannten Aufzeichnungsmaterialien V1 und V2 verdeutlicht die Überlegenheit der erfindungsgemäßen Aufzeichnungsmaterialien I.

In der nachfolgenden Tabelle 1 haben die Abkürzungen die folgende Bedeutung:

$(a_1)$      Bindemittel;

$(a_{11})$      EPDM-Kautschuk ®Buna AP 241 BMH der Firma Hüls GmbH (Ethylengehalt: 50 Gew.%; Doppelbindungsanteil: 8 Doppelbindungen je 1000 Kohlenstoffatome);

$(a_{12})$      EPDM-Kautschuk ®Buna AP 447 der Firma Hüls Gmbh (Ethylengehalt: 70 Gew.%; Doppelbindungsanteil: 8 Doppelbindungen je 1000 Kohlenstoffatome);

$(a_{13})$      EPDM-Kautschuk ®Buna AP 251 der Firma Hüls GmbH (Ethylengehalt: 50 Gew.%; Doppelbindungsanteil: 14 Doppelbindungen je 1000 Kohlenstoffatome);

$(a_2)$      Photoinitiator, Benzildimethylacetal;

$(a_3)$      Monomer;

$(a_{31})$      Isobornylacrylat;

$(a_{32})$      Dihydrodicyclopentadienylacrylat;

$(a_{33})$      Hex-1-en-6-ylacrylat;

($a_{34}$)     Thio-diethylenglykol-diacrylat;
($a_4$)       Hilfsstoffe;
($a_{41}$)     Adipinsäure-di-n-octylester (Dioctyladipat);
($a_{42}$)     naphthenischer Weichmacher (Aromatengehalt kleiner als 10 Gew.%; Schwefelgehalt kleiner als 2 Gew.%);
($a_{43}$)     Polybutadien; Molekulargewicht 100;
($a_{44}$)     Pentaerylthrithol-tetrathioglykonat;
($a_{45}$)     Phthalocyaninfarbstoff Siccoflush D (C.I. 74260);
($a_{46}$)     2,6-Di-tert.-butyl-p-kresol;
X-Y-X      übliches und bekanntes Styrol-Isopren-Styrol-Dreiblockmischpolymerisat;
X-Y-Z      übliches und bekanntes Dreiblockmischpolymerisat aus einem Styrolblock X, einem Isoprenblock Y und einem Styrol-Butadien-Copolymerisatblock Z;
HDA2       Hexandioldiacrylat;
HDMA2      Hexandioldimethacrylat;
WÖ         Weißöl, ein übliches und bekanntes Paraffinöl;
Cl-P       Chlorparaffin, ®Hordaflex LC50 der Firma Hoechst AG;
SSBB       Sudantiefschwarz 88 (C.I. 26150);
OZ         übliches und bekanntes Ozonschutzwachs, ®Antilux 1550 der Firma Rheinchemie;

Tabelle 1:   Die stoffliche Zusammensetzung der neuen photopolymerisierbaren reliefbildenden Schichten (A) in erfindungsgemäßen Aufzeichnungsmaterialien I (Beispiele 1 bis 8) im Vergleich mit der Zusammensetzung bekannter photopolymerisierbarer reliefbildender Schichten in bekannten Aufzeichnungsmaterialien (Vergleichsversuche V1 und V2)

| Beispiel | $(a_1)$ Gew.-Teile | $(a_2)$ Gew.-Teile | $(a_3)$ Gew.-Teile | $(a_4)$ Gew.-Teile |
|---|---|---|---|---|
| 1 | $80(a_{11})$ | $1(a_2)$ | $5(a_{31}) + 5(a_{32})$ | $5(a_{41}) + 0,01(a_{45}) + 0,5(a_{46})$ |
| 2 | $80(a_{12})$ | $1(a_2)$ | $5(a_{31}) + 5(a_{32})$ | $5(a_{41}) + 0,01(a_{45}) + 0,5(a_{46})$ |
| 3 | $80(a_{13})$ | $1(a_2)$ | $5(a_{31}) + 5(a_{32})$ | $5(a_{41}) + 0,01(a_{45}) + 0,5(a_{46})$ |
| 4 | $80(a_{11})$ | $1(a_2)$ | $5(a_{31}) + 5(a_{32})$ | $5(a_{42}) + 0,01(a_{45}) + 0,5(a_{46})$ |
| 5 | $80(a_{11})$ | $1(a_2)$ | $5(a_{31}) + 5(a_{32})$ | $5(a_{42}) + 0,01(a_{43}) + 0,01(a_{45}) + 0,5(a_{46})$ |
| 6 | $80(a_{11})$ | $1(a_2)$ | $5(a_{31}) + 5(a_{32})$ | $5(a_{42}) + 0,01(a_{44}) + 0,01(a_{45}) + 0,5(a_{46})$ |
| 7 | $80(a_{11})$ | $1(a_2)$ | $10(a_{33})$ | $5(a_{41}) + 0,01(a_{45}) + 0,5(a_{46})$ |
| 8 | $80(a_{11})$ | $1(a_2)$ | $10(a_{34})$ | $0,01(a_{45}) + 0,5(a_{45}) + 0,5(a_{46})$ |
| Vergleichs-versuch | | | | |
| V1 | 80X-Y-X | $1(a_2)$ | 5HDA2 + 5HDMA2 | 5WÖ + 0,01 SSBB + 0,5$(a_{46})$ |
| V2 | 80X-Y-Z | $1(a_2)$ | 5HDA2 + 5HDMA2 | 5Cl-P + 0,01 SSBB + 0,5$(a_{46})$ |

EP 0 326 977 B1

Tabelle 2:    Versuchsergebnisse

| Beispiel Nr. | Aufzeichnungsmaterial | Ozonresistenz (min) | Quellung in dem Flexodruckfarbenlösungsmittel a) F1 (%) | b) F2 (%) | Shore A | Reißdehnung (%) | Reißkraft (N/mm$^2$) | Minidefo Belastung (%) | Entlastung (%) | Belichtungsspielraum | Auflage beim Drucken mit einer Flexodruckfarbe auf der Basis b) F2 |
|---|---|---|---|---|---|---|---|---|---|---|---|
| 1 | I-1 | > 480 | 6,3 | 7,2 | 40 | 480 | 0,9 | 79,2 | 96,7 | positiv | > 10$^6$ |
| 2 | I-2 | > 480 | 3,8 | 4,1 | 70 | 360 | 1,4 | 95 | 99,4 | positiv | > 10$^6$ |
| 3 | I-3 | > 480 | 6,5 | 7,8 | 65 | 320 | 1,5 | 97,7 | 99,2 | positiv | > 10$^6$ |
| 4 | I-4 | > 480 | 7,4 | 8,1 | 43 | - | - | - | - | positiv | > 10$^6$ |
| 5 | I-5 | > 480 | 8,2 | 9,8 | 45 | - | - | - | - | positiv | > 10$^6$ |
| 6 | I-6 | > 480 | 7,9 | 9,3 | 49 | - | - | - | - | positiv | > 10$^6$ |
| 7 | I-7 | > 480 | 4,3 | 6,8 | 42 | - | - | - | - | positiv | > 10$^6$ |
| 8 | I-8 | > 480 | 6,8 | 7,4 | 38 | - | - | - | - | positiv | > 10$^6$ |
| Vergleichsversuche | | | | | | | | | | | |
| V1 | | < 10 | > 250 | > 250 | 60 | 170 | 1,8 | 91,6 | 99,2 | positiv | > 10$^5$ |
| V2 | | > 360 | > 300 | > 300 | 47 | 140 | 1,4 | 83,7 | 97,8 | positiv | > 10$^5$ |

a) Flexodruckfarbenlösungsmittel aus 50 Gew.Teilen Ethanol und 50 Gew.Teilen Essigester;

b) Flexodruckfarbenlösungsmittel aus 50 Gew.Teilen Ethanol, 35 Gew.Teilen Essigester und 30 Gew.Teilen Methylethylketon;

EP 0 326 977 B1

Beispiel 9

Die Herstellung erfindungsgemäßer Aufzeichnungsmaterialien I und ihre Weiterverarbeitung zu neuen Flexodruckplatten

Beispiel 1, Tabelle 1, wurde wiederholt, nur daß anstelle der Polyamidschicht (C) eine Deckschicht (C) aus einem Ethylen-Propylen-Copolymerisat (EPM) eines Ethylengehalts von 55 Gew.% verwendet wurde und daß anstelle des Entwicklers Perchlorethylen Petroleum eines Siedepunktes von 185 bis 210°C Verwendung fand.

Das resultierende erfindungsgemäße Aufzeichnungsmaterial I-9 wies die gleichen vorzüglichen Eigenschaften auf wie die erfindungsgemäßen Aufzeichnungsmaterialien I-1 bis I-8 (Tabellen 1 und 2, Beispiele 1 bis 8) und lieferte eine neue Flexodruckplatte mit gleichmäßig matter Oberfläche.

Beispiel 10

Die Herstellung erfindungsgemäßer Aufzeichnungsmaterialien I und ihre Weiterverarbeitung zu neuen Flexodruckplatten

Beispiel 1 wurde wiederholt, nur daß die neue Schicht (A) statt einer Dicke von 2900 μm eine Dicke von 1000 μm (=Beispiel I-1a) aufwies.

Im Unterschied zu der bei den Beispielen 1 bis 8 angegebenen allgemeinen Vorschrift wurde der temporäre Schichtträger (B) des erfindungsgemäßen Aufzeichnungsmaterials I-1a mit dem Aufbau "(B), (A), (C) und (D)" von der neuen Schicht (A) abgezogen, ohne daß diese vollflächig belichtet worden wäre.

Das resultierende erfindungsgemäße Aufzeichnungsmaterial I-1a mit dem Aufbau "(A), (C) und (D)" wurde anschließend mit der freien Seite seiner neuen Schicht (A) auf die freie Seite einer 2300 μm dicken, mit einer 125 μm starken Polyethylenterephthalatfolie (B) haftfest verbundenen, photopolymerisierbaren reliefbildenden Schicht der bekannten Zusammensetzung V1, Tabelle 1, Vergleichsversuch V1, aufkaschiert.

Das in dieser Weise hergestellte, erfindungsgemäße Aufzeichnungsmaterial I-10 mit dem Aufbau "(B), bekannte Schicht V1, neue Schicht (A), (C) und (D)" wurde hiernach gemäß der bei den Beispielen 1 bis 8 angegebenen allgemeinen Versuchsvorschrift - allerdings ohne den Träger (B) hierbei zu entfernen - weiterverarbeitet, wobei die Belichtungs- und Entwicklungsbedingungen so gewählt wurden, daß eine Reliefschicht (A′) resultierte, deren maximalen Tiefen bis zur Oberfläche des Trägers (B) hinabreichten. Die in dieser Weise erhaltene neue Flexodruckplatte mit der Reliefschicht (A′) wies eine gleichmäßig matte Oberfläche und ein hervorragendes Druckverhalten auf.

Beispiel 11

Die Herstellung erfindungsgemäßer Aufzeichnungsmaterialien I und ihre Weiterverarbeitung zu neuen Flexodruckplatten

Beispiel 10 wurde wiederholt, nur daß man hierbei anstelle der bekannten Schicht der Zusammensetzung V1, Tabelle 1, Vergleichsversuch V1, die bekannte Schicht der Zusammensetzung V2, Tabelle 1, Vergleichsversuch V2, verwendet und daß das erfindungsgemäße Aufzeichnungsmaterial I-11 mit dem Aufbau "(B), bekannte Schicht V2, neue Schicht (A), (C) und (D)" vor seiner bildmäßigen Belichtung und Entwicklung von seiner Rückseite her durch den Träger (B) hindurch vollflächig mit aktinischem Licht belichtet wurde. Hiernach wurde das erfindungsgemäße Aufzeichnungsmaterial I-11, wie bei Beispiel 10 angegeben, weiterverarbeitet. Hierbei resultierte eine neue Flexodruckplatte, deren Reliefschicht (A′) wegen der rückseitigen Vorbelichtung lediglich Tiefen von maximal 700 μm aufwies. Auch diese neue Flexodruckplatte hatte eine gleichmäßig matte Oberfläche und wies ein hervorragendes Druckverhalten auf.

Beispiele 12 bis 14

Die Herstellung erfindungsgemäßer Aufzeichnungsmaterialien I und ihre Weiterverarbeitung zu neuen Flexodruckplatten

Allgemeine Versuchsvorschrift:

Die Komponenten $(a_1)$, $(a_2)$, $(a_3)$ und $(a_4)$ der neuen photopolymerisierbaren reliefbildenden Schicht (A) wurden in dem gewünschten Gewichtsverhältnis und in einer solchen Gesamtmenge in Toluol gelöst, daß eine 25 %ige Beschichtungslösung resultierte. Diese Beschichtungslösung wurde auf die mit einem Polyurethan-Haftlack versehene Seite einer 125 μm dicken Polyethylenterephthalatfolie (B) so aufgegossen, daß nach dem Trocknen der Naßschicht eine 1000 μm dicke neue Schicht (A) vorlag.

Auf die freie Seite dieser neuen Schicht (A) wurde eine mit einer 5 μm dicken Polyamidschicht (C) versehene, 75 μm starke, mattierte Polyethylenterephthalatfolie (D) aufkaschiert, so daß ein erfindungsgemäßes Aufzeichnungsmaterial I des Aufbaus "(B), (A), (C) und (D)" resultierte.

Dieses erfindungsgemäße Aufzeichnungsmaterial I wurde, wie in Beispiel 11 angegeben, zu dem erfindungsgemäßen Aufzeichnungsmaterial I mit dem Aufbau "(B), bekannte Schicht V2, neue Schicht (A), (C) und (D)" weiterverarbeitet. Dieses wurde gemäß Beispiel 11 belichtet und entwickelt. Hierbei resultierte eine neue Flexodruckplatte, deren Reliefschicht (A') wegen der rückseitigen Vorbelichtung lediglich Tiefen von maximal 700 μm aufwies.

Nach dieser allgemeinen Vorschrift wurden die erfindungsgemäßen Aufzeichnungsmaterialien I-12, I-13 und I-14 hergestellt.

– Dabei fand bei Beispiele 12, Aufzeichnungsmaterial I-12, ein
– Gemisch (A) der Zusammensetzung gemäß Beispiel 1, Tabelle 1,
– bei Beispiel 13, Aufzeichnungsmaterial I-13, ein Gemisch (A) der Zusammensetzung gemäß Beispiel 2, Tabelle 1, und
– bei Beispiel 14, Aufzeichnungsmaterial I-14, ein Gemisch (A) der Zusammensetzung gemäß Beispiel 3, Tabelle 1,

Verwendung.

Die aus den erfindungsgemäßen Aufzeichnungsmaterialien I-12, I-13 und I-14 nach der allgemeinen Vorschrift hergestellten neuen Flexodruckplatten wiesen allesamt eine gleichmäßig matte Oberfläche auf und gaben die Motive der Testnegativvorlage detailgetreu wieder. Ihr Druckverhalten war hervorragend und sie lieferten exzellente Druckerzeugnisse in einer Auflage von jeweils mehr als $10^6$.

## Patentansprüche

1. Flächenförmiges lichtempfindliches Aufzeichnungsmaterial I, das ein polymeres Bindemittel, einen Initiator, ein Monomeres mit mindestens einer photopolymerisierbaren Doppelbindung und gegebenenfalls Hilfsstoffe enthält, dadurch gekennzeichnet, daß es mindestens eine photopolymerisierbare reliefbildende Schicht (A) enthält, welche, bezogen auf (A),

$a_1$) 20 bis 99,499 Gew.% mindestens eines polymeren Bindemittels aus der Gruppe der statistischen Ethylen-Propylen-Alkadien-Terpolymerisate eines Ethylengehalts von 40 bis 80 Gew.% und eines Doppelbindungsanteils von 2 bis 20 olefinischen Doppelbindungen je 1000 Kohlenstoffatome,

$a_2$) 0,001 bis 10 Gew.% mindestens eines Initiators der Photopolymerisation,

$a_3$) 0,5 bis 50 Gew.% mindestens eines Monomeren, welches mit dem Bindemittel (a1) verträglich ist und mindestens eine photopolymerisierbare olefinische Doppelbindung aufweist, und

$a_4$) 0 bis 40 Gew.% mindestens eines Hilfsstoffes, mit dessen Hilfe das Eigenschaftsprofil variiert wird;

enthält.

2. Flächenförmiges lichtempfindliches Aufzeichnungsmaterial I nach Anspruch 1, dadurch gekennzeichnet, daß das statistische Ethylen-Propylen-Alkadien-Terpolymerisat ($a_1$) einen Ethylengehalt von 45 bis 75 Gew.% aufweist.

3. Flächenförmiges lichtempfindliches Aufzeichnungsmaterial I nach Anspruch 1 oder 2, dadurch gekennzeichnet, daß das statistische Ethylen-Propylen-Alkadien-Terpolymerisat ($a_1$) einen Doppelbindungsanteil von 4 bis 15 olefinischen Doppelbindungen je 1000 Kohlenstoffatome aufweist.

4. Flächenförmiges lichtempfindliches Aufzeichnungsmaterial I nach einem der Ansprüche 1 bis 3, dadurch gekennzeichnet, daß das Alkadien aus der Gruppe, welche Dicyclopentadien, Ethylidennorbornen und trans-Hexa-1,4-dien enthält, ausgewählt wird.

5. Flächenförmiges lichtempfindliches Aufzeichnungsmaterial I nach einem der Ansprüche 1 bis 4, dadurch gekennzeichnet, daß das Monomere ($a_3$) aus der Gruppe, welche Isobornylacrylat, Isobornylmethacrylat, Dihydrodicyclopentadienylacrylat, Dihydrodicyclopentadienylmethacrylat, Hex-1-en-6-yl-acrylat, Hex-1-en-6-yl-methacrylat, Dihydroxylimonendiacrylat, Dihydroxylimonendimethacrylat, Dicyclopentyldimethylendiacrylat, Dicyclopentyldimethylendimethacrylat, Thio-diethylenglykoldiacrylat, Thio-diethylenglykol-dimethacrylat, Benzylacrylat, Benzylmethacrylat, Dodecandiol-diacrylat, Dodecandiol-dimethacrylat, Fumarsäure-di-n-butylester, Fumarsäure-di-n-octylester, Diallylphthalat, Divinylbenzol und Itaconsäurebisallylester enthält, ausgewählt wird.

6. Flächenförmiges lichtempfindliches Aufzeichnungsmaterial I nach einem der Ansprüche 1 bis 5 mit einem dimensionsstabilen Träger (B).

7. Flächenförmiges lichtempfindliches Aufzeichnungsmaterial I nach einem der Ansprüche 1 bis 6 mit einer lichtdurchlässigen, glatten oder mattierten, nicht klebrigen Deckschicht (C).

8. Flächenförmiges lichtempfindliches Aufzeichnungsmaterial I nach einem der Ansprüche 1 bis 7 mit einer glatten oder mattierten Deckfolie (D).

9. Verwendung der flächenförmigen lichtempfindlichen Aufzeichnungsmaterialien I gemäß einem der Ansprüche 1 bis 8 für die Herstellung von Reliefplatten, Reliefdruckplatten und Photoresists.

10. Verfahren zur Herstellung von Reliefplatten, Reliefdruckplatten und Photoresists durch
(i) bildmäßiges Belichten der photopolymerisierbaren reliefbildenden Schicht (A) eines flächenförmigen lichtempfindlichen Aufzeichnungsmaterials mit aktinischem Licht,
und durch
(ii) Auswaschen (Entwickeln) der unbelichteten und daher nicht photopolymerisierten Bereiche der bildmäßig belichteten reliefbildenden Schicht (A) mit einem Entwickler unter Bildung einer Reliefschicht (A'),
dadurch gekennzeichnet, daß man hierzu ein flächenförmiges lichtempfindliches Aufzeichnungsmaterial I gemäß einem der Ansprüche 1 bis 8 verwendet.

## Claims

1. A sheetlike light-sensitive recording material I comprising a polymeric binder, an initiator, a monomer having at least one photopolymerizable double bond and, optionally, assistants, which comprises at least one photopolymerizable relief-forming layer (A) comprising, based on (A),
$a_1$) from 20 to 99.499% by weight of at least one polymeric binder from the group consisting of random ethylene-propylene-alkadiene terpolymers having an ethylene content of from 40 to 80% by weight and a double bond content of from 2 to 20 olefinic double bonds per 1,000 carbon atoms,
$a_2$) from 0.001 to 10% by weight of at least one photopolymerization initiator,
$a_3$) from 0.5 to 50% by weight of at least one monomer which is compatible with said binder ($a_1$) and has at least one photopolymerizable olefinic double bond, and
$a_4$) from 0 to 40% by weight of at least one assistant with whose assistance the range of properties is varied.

2. The sheetlike light-sensitive recording material I as claimed in claim 1, wherein the random ethylene-propylene-alkadiene terpolymer ($a_1$) has an ethylene content of from 45 to 75% by weight.

3. The sheetlike light-sensitive recording material I as claimed in claim 1 or 2, wherein the random ethylene-propylene-alkadiene terpolymer ($a_1$) has a double bond content of from 4 to 15 olefinic double bonds per 1,000 carbon atoms.

4. The sheetlike light-sensitive recording material I as claimed in any one of claims 1 to 3, wherein the alkadiene is selected from the group consisting of dicyclopentadiene, ethylidenenorbomene and trans-1,4-hexadiene.

5. The sheetlike light-sensitive recording material I as claimed in any one of claims 1 to 4, wherein the monomer ($a_3$) is selected from the group consisting of isobornyl acrylate, isobornyl methacrylate, dihydrodicyclopentadienyl acrylate, dihydrodicyclopentadienyl methacrylate, hex-1-en-6-yl acrylate, hex-1-en-6-yl methacrylate, dihydroxylimonene diacrylate, dihydroxylimonene dimethacrylate, dicyclopentyldimethylene diacrylate, dicyclopentyldimethylene dimethacrylate, thiodiethylene glycol diacrylate, thiodiethylene glycol dimethacrylate, benzyl acrylate, benzyl methacrylate, dodecanediol diacrylate, dodecanediol dimethacrylate, di-n-butyl fumarate, di-n-octyl fumarate, diallyl phthalate, divinylbenzene and bisallyl itaconate.

6. The sheetlike light-sensitive recording material I as claimed in any one of claims 1 to 5 comprising a dimensionally stable base (B).

7. The sheetlike light-sensitive recording material I as claimed in any one of claims 1 to 6 comprising a transparent smooth or matted nontacky top layer (C).

8. The sheetlike light-sensitive recording material I as claimed in any one of claims 1 to 7 comprising a smooth or matted cover sheet (D).

9. The use of the sheetlike light-sensitive recording material I as claimed in any one of claims 1 to 8 for producing relief plates, relief printing plates and photoresists.

10. A process for producing relief plates, relief printing plates and photoresists by
   (i) subjecting the photopolymerizable relief-forming layer (A) of a sheetlike light-sensitive recording material to imagewise exposure under actinic light
   and by
   (ii) washing out (developing) the unexposed and therefore nonphotopolymerized areas of the imagewise exposed relief-forming layer (A) with a developer to form a relief layer (A'),
   which comprises using for this purpose a sheetlike light-sensitive recording material I as claimed in any one of claims 1 to 8.

## Revendications

1. Matériau d'enregistrement planiforme photosensible I contenant un liant polymère, un inducteur, un monomère à au moins une double liaison photopolymérisable et le cas échéant des produits auxiliaires, caractérisé en ce qu'il contient au moins une couche photopolymérisable pour formation de relief (A) contenant, par rapport à (A),
   a1) 20 à 99,499 % en poids d'au moins un liant polymère du groupe des copolymères ternaires statistiques éthylène-propylène-alcadiène d'une teneur en éthylène de 40 à 80 % en poids et une teneur en doubles liaisons de 2 à 20 doubles liaisons oléfiniques pour 1000 atomes de carbone,
   a2) 0,001 à 10 % en poids d'au moins un inducteur de la photopolymérisation,
   a3) 0,5 à 50 % en poids d'au moins un monomère compatible avec le liant a1) et qui contient au moins une double liaison oléfinique photopolymérisable, et
   a4) 0 à 40 % en poids d'au moins un produit auxiliaire à l'aide duquel on fait varier le profil des propriétés.

2. Matériau d'enregistrement planiforme photosensible I selon la revendication 1, caractérisé en ce que le copolymère ternaire statistique éthylène-propylène-alcadiène a1) a une teneur en éthylène de 45 à 75 % en poids.

3. Matériau d'enregistrement planiforme photosensible I selon la revendication 1 ou 2, caractérisé en ce que le copolymère ternaire statistique éthylènepropylène-alcadiène a1) a une teneur en doubles liaisons de 4 à 15 doubles liaisons oléfiniques pour 1000 atomes de carbone.

4. Matériau d'enregistrement planiforme photosensible I selon l'une des revendications 1 à 3, caractérisé en ce que l'alcadiène est choisi dans le groupe formé par le dicyclopentadiène, l'éthylidène-norbornène et le trans-hexa-1,4-diène.

5. Matériau d'enregistrement planiforme photosensible I selon l'une des revendications 1 à 4, caractérisé en ce que le monomère a3) est choisi dans le groupe formé par l'acrylate d'isobornyle, le méthacrylate d'isobornyle, l'acrylate de dihydrodicyclopentadiényle, le méthycrylate de dihydrodicyclopentadiényle, l'acrylate d'hexa-1-ène-6-yle, le méthacrylate d'hexa-1-ène-6-yle, le diacryalte du dihydroxylimonène, le diméthacrylate du dihydroxylimonène, le diacrylate du dicyclopentyldiméthylène, le diméthacrylate du dicyclopentyldiméthylène, le diacrylate du thio-diéthylène-glycol, le diméthacrylate du thio-diéthylène-glycol, l'acrylate de benzyle, le méthacrylate de benzyle, le diacrylate de dodécane-diol, le diméthacrylate du dodécane-diol, le fumarate de di-n-butyle, le fumarate de di-n-octyle, le phtalate de diallyle, le divinylbenzène et l'itaconate de bis-allyle.

6. Matériau d'enregistrement planiforme photosensible I selon une des revendications 1 à 5, avec un support de dimensions stables B.

7. Matériau d'enregistrement planiforme photosensible I selon une des revendications 1 à 6, avec une couche de couverture perméable à la lumière, lisse ou matée, non collante C.

8. Matériau d'enregistrement planiforme photosensible I selon une des revendications 1 à 7, avec une feuille de couverture lisse ou matée D.

9. Utilisation des matériaux d'enregistrement planiformes photosensibles I selon une des revendications 1 à 8 pour la fabrication de plaques à relief, de plaques pour l'impression en relief et de photoréserves.

10. Procédé pour la fabrication de plaques en relief, de plaques pour l'impression en relief et de photoréserves par :
    (i) exposition à la lumière avec formation d'une image de la couche photopolymérisable formant relief A d'un matériau d'enregistrement photosensible planiforme, à la lumière actinique,
    et par
    (ii) lavage (développement) des régions non éclairées et par conséquent non photopolymérisées de la couche formant relief A exposée à la lumière avec formation d'une image, au moyen d'un révélateur, avec formation d'une couche en relief A', caractérisé en ce que l'on utilise à cet effet un matériau d'enregistrement planiforme photosensible I selon une des revendications 1 à 8.